(19) Europäisches Patentamt
European Patent Office
Office européen des brevets

(11) Veröffentlichungsnummer: **0 050 802**
**B1**

(12) # EUROPÄISCHE PATENTSCHRIFT

(45) Veröffentlichungstag der Patentschrift: **10.04.85**

(51) Int. Cl.⁴: **G 03 F 7/08**, G 03 F 7/10

(21) Anmeldenummer: **81108356.7**

(22) Anmeldetag: **15.10.81**

(54) **Lichtempfindliches Gemisch, daraus hergestelltes lichtempfindliches Kopiermaterial und Verfahren zur Herstellung einer Druckform aus dem Kopiermaterial.**

(30) Priorität: **23.10.80 DE 3039926**

(43) Veröffentlichungstag der Anmeldung: **05.05.82 Patentblatt 82/18**

(45) Bekanntmachung des Hinweises auf die Patenterteilung: **10.04.85 Patentblatt 85/15**

(84) Benannte Vertragsstaaten: **DE FR GB**

(56) Entgegenhaltungen:
**EP - A - 0 006 561**
**EP - A - 0 012 956**
**DE - A - 2 547 905**

(73) Patentinhaber: **HOECHST AKTIENGESELLSCHAFT, Postfach 80 03 20, D-6230 Frankfurt am Main 80 (DE)**

(72) Erfinder: **Stahlhofen, Paul, Dr., Leibnizstrasse 18, D-6200 Wiesbaden (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

**Beschreibung**

Die Erfindung betrifft ein lichtempfindliches Gemisch, das ein wasserunlösliches, in wässrig-alkalischen Lösungen lösliches Bindemittel und eine lichtempfindliche Verbindung enthält, ein lichtempfindliches Kopiermaterial aus einem Schichtträger und einer lichtempfindlichen Schicht, die aus dem Gemisch besteht, sowie ein Verfahren zur Herstellung einer Druckform durch Belichten, Entwickeln und Erhitzen des Kopiermaterials.

Verfahren zur Herstellung von Druckformen durch Erhitzen bzw. Einbrennen der Bildschicht von belichteten und entwickelten Kopiermaterialien sind z.B. aus den britischen Patentschriften 1 151 199 und 1 154 749 bekannt. Dabei wird entweder ein positiv arbeitendes, bevorzugt ein o-Chinodiazid enthaltendes, oder negativ arbeitendes, bevorzugt ein p-Chinondiazid enthaltendes lichtempfindliches Kopiermaterial bildmässig belichtet, entwickelt und danach auf eine oberhalb 180°C liegende Temperatur so lange und so hoch erhitzt, dass der zuvor sauber entwickelte Bildhintergrund durch Wärmezersetzungsprodukte der Bildschicht verschmutzt wird. Danach wird der Bildhintergrund durch nochmaliges Behandeln mit Entwicklerlösung wieder gesäubert. Normalerweise werden beim Erhitzen Temperaturen von 220–240°C angewendet, und die Dauer des Erhitzens beträgt etwa 5–60 Minuten. Durch diese Nachbehandlung wird eine Verfestigung der Druckschicht und damit eine erhebliche Erhöhung der Druckauflage erreicht. Wenn die Einbrenntemperaturen an der oberen Grenze des angegebenen Bereichs liegen, sind naturgemäss relativ kurze Einbrennzeiten erforderlich. Es hat sich gezeigt, dass die Anwendung höherer Temperaturen bei diesem Verfahren nachteilig ist. Sie bewirken einmal die Ausbildung eines verhältnismässig festsitzenden Niederschlags auf den Hintergrundstellen, der nur durch relativ aggressive Lösungen sauber entfernt werden kann, wobei auch die Gefahr eines Angriffs auf die Druckschablone besteht. Zum zweiten besteht bei den höheren Einbrenntemperaturen oder bei längeren Einbrennzeiten die Gefahr, dass sich die üblicherweise verwendeten Schichtträger aus Aluminium verformen und die erhaltenen Druckformen geschädigt oder unbrauchbar werden.

Der zuerstgenannte Nachteil kann, wie es in der DE-OS 2 626 473 beschrieben ist, dadurch vermieden werden, dass man die Hintergrundfläche vor dem Einbrennen mit einer Schicht einer wasserlöslichen organischen Substanz oder eines anorganischen Salzes überzieht, die sich nach dem Einbrennen leicht abwaschen lässt. Um die Verformung des Trägers zu verhindern, wäre es jedoch wünschenswert, bei tieferen Temperaturen einbrennen zu können.

Aus der DE-OS 2 547 905 ist ein lichtempfindliches Gemisch der hier beschriebenen Gattung bekannt, das neben einem o-Chinodiazid und einem alkalilöslichen Bindemittel ein niedermolekulares Phenolderivat, z.B. 2,3,4-Trihydroxy-benzophenon, enthält. Das Phenolderivat hat den Zweck, die Haftung der lichtempfindlichen Schicht auf dem Schichtträger unabhängig von einem möglichen Einbrennschritt zu verbessern.

Aufgabe der Erfindung war es, ein lichtempfindliches Gemisch bzw. ein daraus hergestelltes Kopiermaterial bereitzustellen, das ein Einbrennen bei niedrigeren Temperaturen erlaubt, ohne dass dadurch die Auflagenleistung der eingebrannten Druckform zurückgeht.

Die Erfindung geht aus von einem lichtempfindlichen Gemisch, das ein wasserunlösliches, in wässrig-alkalischen Lösungen lösliches Bindemittel, ein lichtempfindliches o- oder p-Chinondiazid oder ein Gemisch aus

a) einer bei Belichtung Säure abspaltenden Verbindung und

b) einer Verbindung mit mindestens einer durch Säure spaltbaren C–O–C-Gruppe und ein Phenolderivat enthält.

Das erfindungsgemässe Gemisch ist dadurch gekennzeichnet, dass das Phenolderivat eine Verbindung mit 1 bis 3 Benzolkernen, die durch Einfachbindungen, Carbonyl-, Ether-, Thioether- oder gegebenenfalls substituierte Methylengruppen miteinander verbunden sind, mit mindestens einer phenolischen Hydroxygruppe und mindestens zwei Substituenten der Formel $-CH_2OR$ ist, worin R ein Wasserstoffatom, eine niedere Alkyl- oder Acylgruppe ist.

Erfindungsgemäss wird weiterhin ein lichtempfindliches Kopiermaterial vorgeschlagen, das aus einem Schichtträger und einer lichtempfindlichen Schicht aus dem oben definierten Gemisch besteht.

Erfindungsgemäss wird ferner ein Verfahren zur Herstellung einer Druckform vorgeschlagen, bei dem ein lichtempfindliches Kopiermaterial, bestehend aus einem Schichtträger und einer lichtempfindlichen Schicht, die ein wasserunlösliches, in wässrig-alkalischen Lösungen lösliches Bindemittel, ein lichtempfindliches o- oder p-Chinondiazid oder ein Gemisch aus

a) einer bei Belichtung Säure abspaltenden Verbindung und

b) einer Verbindung mit mindestens einer durch Säure spaltbaren C–O–C-Gruppe

und ein Phenolderivat enthält, bildmässig belichtet wird, die Nichtbildstellen der Schicht mit einer wässrig-alkalischen Entwicklerlösung ausgewaschen werden und das Material danach zur Verfestigung der Bildschicht auf erhöhte Temperatur erhitzt wird, das dadurch gekennzeichnet ist, dass man das oben definierte lichtempfindliche Kopiermaterial verwendet.

Die in dem erfindungsgemässen Gemisch enthaltenen Phenolderivate können z.B. einer der allgemeinen Formeln I und II

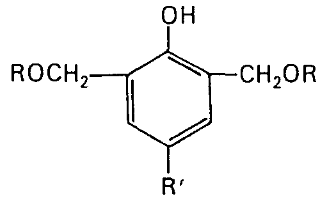

I

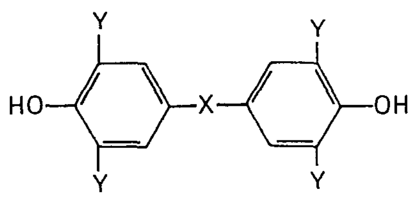

II

entsprechen, worin

R ein Wasserstoffatom, eine niedere Alkylgruppe oder eine niedere Acylgruppe,

R′ eine Alkyl-, Alkoxy-, Cycloalkyl-, Aryl-, Aryloxy-, Acyl-, Aralkylgruppe oder ein Halogenatom,

X eine Einfachbindung oder eine der Gruppen S, O, CO oder $CR^1R^2$ und

Y ein Wasserstoffatom oder eine $CH_2OR$-Gruppe bedeutet, wobei

$R^1$ und $R^2$ gleich oder verschieden sind und Wasserstoffatome, substituierte oder unsubstituierte Alkylgruppen bedeuten, die miteinander zu einem Ring verbunden sein können, und wobei nicht mehr als zwei der Substituenten Y Wasserstoffatome sind.

Allgemein werden wegen ihrer grösseren Reaktionsfähigkeit die Verbindungen bevorzugt, in denen R ein Wasserstoffatom ist. Wenn R eine Alkylgruppe ist, hat diese normalerweise 1 bis 4 Kohlenstoffatome und ist vorzugsweise eine Methylgruppe. Von den niederen Acylgruppen werden solche mit 2 bis 4 Kohlenstoffatomen, insbesondere die Acetylgruppe, bevorzugt.

Wegen ihrer hohen Vernetzungswirkung werden die Verbindungen der Formel II, insbesondere die Vertreter, in denen alle Y $CH_2OR$-Gruppen sind, bevorzugt.

Von diesen Verbindungen werden ferner diejenigen bevorzugt, in denen X eine Methylengruppe, vor allem eine substituierte Methylengruppe, ist. Verbindungen mit X = Prop-2,2-ylen werden am meisten bevorzugt. Als Substituenten für die Methylengruppe kommen z.B. Alkylgruppen, Alkoxyalkylgruppen, Carboxyalkylgruppen, Hydroxyalkylgruppen, Acylalkylgruppen, Acyloxyalkylgruppen, Alkoxycarbonylalkylgruppen oder Halogenalkylgruppen mit jeweils 1 bis 5 Kohlenstoffatomen in Betracht. Wenn die Substituenten zu einem Ring verbunden sind, hat dieser bevorzugt 5 oder 6 Glieder.

Von den Verbindungen der Formel I werden diejenigen bevorzugt, in denen R′ eine Alkylgruppe mit 1 bis 12 Kohlenstoffatomen, eine Cycloalkylgruppe mit 5 bis 8 Kohlenstoffatomen, eine Alkoxygruppe mit 1 bis 5 Kohlenstoffatomen, eine Arylgruppe mit 6 bis 10 Kohlenstoffatomen, eine Aralkylgruppe mit 7 bis 10 Kohlenstoffatomen, ein Chlor- oder Bromatom ist.

Die Herstellung der Phenolalkohole der Formel I erfolgt durch Umsetzen des entsprechenden Phenolderivats mit Formaldehyd in stark alkalischem Medium bei Temperaturen von etwa 15–50°C, vorzugsweise bei Zimmertemperatur.

Je nach der Aktivität des Ausgangsphenols und der Menge des eingesetzten Formaldehyds verläuft die Umsetzung in Zeiträumen von weniger als einer Stunde bis zu mehreren Tagen. Durch vorsichtige Neutralisation mit verdünnter Salzsäure werden die freien Phenolalkohole entweder in hochviskoser oder in kristalliner Form abgeschieden. Die Reaktionsprodukte werden im Vakuum bei einer zwischen Raumtemperatur und 50°C liegenden Innentemperatur entwässert.

In der folgenden Tabelle werden einige der 4-substituierten Hydroxymethyl-phenole gemäss der allgemeinen Formel I aufgeführt, die als Zusatz zu dem erfindungsgemässen Gemisch geeignet sind.

| R′ | Schmp. °C |
|---|---|
| Methyl | 130 |
| Ethyl | 86 |
| n-Octyl | 73 |
| n-Butyl | 67 |
| tert.-Butyl | 74 |
| Methoxy | 128 |
| Phenyl | 111 |
| Benzyl | 86 |
| Cyclohexyl | 106–107 |
| Chlor | 156 |
| Brom | 152 |

Einige der aufgeführten Hydroxymethylphenole sind beschrieben in Journal für praktische Chemie Bd. 152 (1939), S. 126; Bd. 153 (1939), S. 327 und in der Monographie von R.W. Martin: The Chemistry of Phenolic Resins.

In der folgenden Tabelle werden einige geeignete Phenolalkohole der Formel II aufgeführt, worin alle Y = $CH_2OH$ bedeuten.

| X | Schmp. °C |
|---|---|
| Methylen | 145 |
| Prop-2,2-ylen | – |
| Cyclohex-1,1-ylen | 115 |
| 1,1,1-Trichlor-eth-2,2-ylen | $>300$ |
| 4-Carboxy-but-2,2-ylen | 120 |
| Einfachbindung | 125 |

Wegen der besseren Stabilität und Lagerfähigkeit der damit erhaltenen erfindungsgemässen lichtempfindlichen Gemische werden die in 4-Stellung zur OH-Gruppe substituierten Hydroxymethylphenole bevorzugt, da Methylolgruppen in o-Stellung zur phenolischen OH-Gruppe durch intramolekulare Wasserstoffbrücken unter Bildung sechsgliedriger Chelatringe stabilisiert werden. Erst durch Erhitzen wird diese Stabilisierung o-ständiger Methylolgruppen aufgehoben, und

es werden Kondensationsreaktionen an den Methylolgruppen ausgelöst, die die Härtung der Schicht bewirken.

Ähnlich wie die freien Phenolakohole verhalten sich entsprechende Verbindungen, bei denen die Methylolgruppen verestert oder verethert sind. Diese Verbindungen reagieren jedoch etwas träger als die Phenolalkohole, so dass sie meist etwas höhere Einbrenntemperaturen erfordern. Sie werden deshalb weniger bevorzugt.

Die Konzentration der Hydroxymethylphenole in dem lichtempfindlichen Gemisch kann in relativ weiten Grenzen schwanken. Im allgemeinen liegt der Anteil bei 5 bis 60, vorzugsweise zwischen 10 und 35 Gew.%, bezogen auf das Gewicht der nicht flüchtigen Bestandteile des lichtempfindlichen Gemisches.

Die erfindungsgemässen lichtempfindlichen Gemische enthalten ferner eine lichtempfindliche Verbindung. Geeignet sind vor allem positiv arbeitende Verbindungen, d.h. solche, die durch Belichten löslich werden. Hierzu gehören o-Chinondiazide und Kombinationen von photolytischen Säurespendern und säurespaltbaren Verbindungen, wie Orthocarbonsäure- und Acetalverbindungen.

Das erfindungsgemässe Gemisch und Verfahren haben besondere Vorteile in Verbindung mit lichtempfindlichen Materialien auf Basis von o-Chinondiaziden, da deren Auflage durch Einbrennen eine besonders grosse Erhöhung erfährt. Geeignete Materialien dieser Art sind bekannt und z.B. in der DE-PS 938 233, den DE-OS 23 31 377, 25 47 905 und 28 28 037 beschrieben. Als o-Chinondiazide werden bevorzugt Naphthochinon-(1,2)-diazid-(2)-4- oder 5-sulfonsäureester oder -amide. Von diesen werden die Ester, insbesondere die der 5-Sulfonsäuren, besonders bevorzugt. Die Menge an o-Chinondiazidverbindungen beträgt im allgemeinen 3 bis 50, bevorzugt 7 bis 35 Gew.-%, bezogen auf die nichtflüchtigen Anteile des Gemischs.

Auch Materialien auf Basis säurespaltbarer Verbindungen lassen sich mit gutem Effekt einbrennen und bei dem erfindungsgemässen Verfahren einsetzen.

Kopiermaterialien dieser Art sind bekannt und z.B. in den US-PS 3 779 778 und 4 101 323, der DE-PS 2 718 254 und den DE-OS 2 829 512 und 2 829 511 beschrieben. Sie enthalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindungen, insbesondere durch Halogenmethylgruppen substituierte s-Triazine.

Von den in der US-PS 4 101 323 beschriebenen Orthocarbonsäurederivaten werden insbesondere die Diphenoxymethylether aliphatischer oder aromatischer Hydroxyverbindungen, die N-Diphenoxymethylderivate von Lactamen sowie ganz besonders die Bis-1,3-dioxan-2-yl-ether von aliphatischen Diolen verwendet.

Von den in der DE-PS 2 718 254 beschriebenen Polyacetalen werden diejenigen mit aliphatischen Aldehyd- und Dioleinheiten bevorzugt.

Weitere gut geeignete Gemische sind in der älteren deutschen Patentanmeldung P 2 928 636.0 beschrieben. Dort werden als säurespaltbare Verbindungen polymere Orthoester mit wiederkehrenden Orthoestergruppen in der Hauptkette beschrieben.

Diese Gruppen sind 2-Alkylether von 1,3-Dioxa-cycloalkanen mit 5 oder 6 Ringgliedern. Besonders bevorzugt werden Polymere mit wiederkehrenden 1,3-Dioxa-cyclohex-2-yl-alkylethereinheiten, in denen die Alkylethergruppe durch Ethersauerstoffatome unterbrochen sein kann und bevorzugt an die 5-Stellung des benachbarten Rings gebunden ist. Ein Teil dieser polymeren Orthoester ist auch in der DE-OS 2 715 502 beschrieben.

Der Mengenanteil der säurespaltbaren Verbindungen in dem lichtempfindlichen Gemisch liegt im allgemeinen zwischen 8 und 65, vorzugsweise zwischen 14 und 44 Gew.%, bezogen auf die nichtflüchtigen Bestandteile des Gemischs. Die Menge der Säure abspaltenden Verbindung liegt zwischen 0,1 und 10, vorzugsweise zwischen 0,2 und 5 Gew.%.

Die erfindungsgemässen lichtempfindlichen Gemische enthalten ferner ein polymeres, wasserunlösliches harzartiges Bindemittel, das sich in den für das erfindungsgemässe Gemisch verwendeten Lösungsmitteln löst und in wässrigen Alkalien ebenfalls löslich oder zumindest quellbar ist.

Die bei vielen Positiv-Kopiermaterialien auf Basis von Naphtochinondiaziden bewährten Novolak-Kondensationsharze haben sich als Zusatz auch bei den erfindungsgemässen Gemischen als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z.B. Kresolen, als Formaldehyd-Kondensationspartner. Die Art und Menge der Novolak-Harze kann je nach Anwendungszweck verschieden sein; bevorzugt sind Novolak-Anteile am Gesamtfeststoff zwischen 90 und 50, besonders bevorzugt von 80–60 Gew.%. Zusätzlich können noch zahlreiche andere Harze mitverwendet werden, bevorzugt Vinylpolymerisate wie Polyvinylacetate, Polyacrylate, Polyvinylether, Polyvinylpyrrolidone und die Mischpolymerisate der ihnen zugrundeliegenden Monomeren. Der günstige Anteil an diesen Harzen richtet sich nach den anwendungstechnischen Erfordernissen und dem Einfluss auf die Entwicklungsbedingungen und beträgt im allgemeinen nicht mehr als 20 Gew.% vom alkalilöslichen Harz. In geringen Mengen kann das lichtempfindliche Gemisch für spezielle Erfordernisse wie Flexibilität, Haftung, Glanz, Färbung und Farbumschlag etc. ausserdem noch Substanzen wie Polyglykole, Cellulose-Derivate wie Ethylcellulose, Netzmittel, Farbstoffe, Haftvermittler und feinteilige Pigmente sowie bei Bedarf UV-Absorber enthalten. Als

weitere alkalilösliche bzw. in Alkali quellbare Bindemittel sind natürliche Harze wie Schellack und Kolophonium und synthetische Harze wie Mischpolymerisate aus Styrol und Aleinsäureanhydrid oder Mischpolymerisate aus Styrol und Maleinsäureanhydrid oder Mischpolymerisate der Acrylsäure oder Methacrylsäure, insbesondere mit Acryl- oder Methacrylsäureestern, zu nennen.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemässe Gemisch sind Ketone, wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykol-monoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Als Schichtträger für Schichtdicken unter ca. 10 µm werden meist Metalle verwendet. Für Offsetdruckplatten können eingesetzt werden: walzblankes, mechanisch oder elektrochemisch aufgerauhtes und ggf. anodisiertes Aluminium, das zudem noch chemisch, z.B. mit Polyvinylphosphonsäure, Silikaten, Hexafluorozirkonaten, hydrolysiertem Tetraethylorthosilikat oder Phosphaten, vorbehandelt sein kann.

Die Beschreibung des Trägermaterials erfolgt in bekannter Weise durch Aufschleudern, Sprühen, Tauchen, Walzen, mittels Breitschlitzdüsen, Rakeln oder durch Giesser-Antrag.

Belichtet wird mit den in der Technik üblichen Lichtquellen. Auch das Bestrahlen mit Elektronen oder Laser stellt eine Möglichkeit zur Bebilderung dar.

Die zum Entwickeln verwendeten wässrig-alkalischen Lösungen abgestufter Alkalität, d.h. mit einem pH, das bevorzugt zwischen 10 und 14 liegt, und die auch kleinere Mengen organischer Lösungs- oder Netzmittel enthalten können, entfernen die vom Licht getroffenen Stellen der Kopierschicht und erzeugen so ein positives Abbild der Vorlage.

Bevorzugte Anwendung finden die erfindungsgemässen lichtempfindlichen Gemische bei der Herstellung von Druckformen, insbesondere Offsetdruckformen, mit Aluminium als Schichtträger.

Nach dem Entwickeln wird die Druckform in an sich bekannter Weise erhitzt. Im Gegensatz zu den bisher beim Einbrennen üblichen Verfahrensbedingungen, wie sie z.B. in der GB-PS 1 154 749 oder der DE-OS 2 939 785 angegeben sind, ist es bei Zusatz der oben definierten Hydroxymethylphenole möglich, die gleiche Erhöhung der Druckauflage wie bisher bei deutlich tieferen Temperaturen bzw. innerhalb wesentlich kürzeren Zeiten zu erreichen. Die Einbrenntemperaturen können im Bereich von etwa 150 bis 240°C, vorzugsweise von 160 bis 210°C, gewählt werden, wobei normalerweise Erhitzungszeiten von 1–20, bevorzugt 5 bis 15 Minuten, erforderlich sind. Wenn das Trägermaterial gegen höhere Temperaturen beständig ist, ist es selbstverständlich auch möglich, bei höheren Temperaturen oberhalb 240°C einzubrennen und dementsprechend kurze Erhitzungszeiten zu wählen.

Der nach dem Entwickeln des Bilds freigelegte Schichtträger kann auch in bekannter Weise vor dem Erhitzen mit der wässrigen Lösung einer filmbildenden Substanz behandelt werden, um die Nachentwicklung nach dem Erhitzen einzusparen oder zumindest zu erleichtern. Diese Behandlung kann auch bei dem erfindungsgemässen Verfahren nützlich sein, sie ist jedoch nicht erforderlich. Insbesondere bei Anwendung der bevorzugten niedrigen Einbrenntemperaturen bilden sich meist gar keine oder leicht entfernbare Niederschläge auf den Hintergrundstellen der Platte aus. Bei der bevorzugten Durchführung des Verfahrens kann deshalb auf diesen Schritt verzichtet werden.

Die Erfindung wird anhand der nachfolgenden Beispiele näher erläutert, in denen Gewichtsteile (Gt) und Volumteile (Vt) im Verhältnis von g zu ccm stehen. Prozente sind, wenn nichts anderes angegeben ist, Gewichtsprozente.

Beispiel 1

Mit einer Lösung von

1,00 Gt des Veresterungsproduktes aus 1 Mol 2,3,4-Trihydroxy-benzophenon und 2 Mol Naphthochinon-(1,2)-diazid-(2)-5-sulfonsäurechlorid,
0,70 Gt des Veresterungsproduktes aus 1 Mol 2,2′-Dihydroxy-dinaphthyl-(1,1′)-methan und 2 Mol Naphthochinon-(1,2)-diazid-(2)-5-sulfonsäurechlorid,
4,25 Gt eines Kresol-Formaldehyd-Novolaks mit einem Erweichungspunkt von 105–120°C,
0,12 Gt 4-(p-Tolylmercapto)-2,5-diethoxy-benzoldiazoniumhexafluorophosphat,
1,30 Gt 2,2-Bis-(4-Hydroxy-3,5-bis-hydroxymethylphenyl)-propan und
0,07 Gt Kristallviolett in
40 Gt Ethylenglykolmonomethylether und
50 Gt Tetrahydrofuran

wurde eine elektrochemisch aufgerauhte und anodisierte Aluminiumplatte beschichtet. Der anodisierte Träger war vor dem Aufbringen der lichtempfindlichen Kopierschicht mit einer wässrigen Lösung von 0,1 Gew.% Polyvinylphosphonsäure behandelt worden, wie es in der DE-PS 1 621 478 beschrieben ist.

Das so hergestellte vorsensibilisierte Material mit einem Schichtgewicht von 2,20 g/m² wurde unter einer transparenten Positiv-Vorlage bildmässig belichtet und anschliessend mit der folgenden Lösung entwickelt:

5,3 Gt Natriummetasilikat × 9 Wasser,
3,4 Gt Trinatriumphosphat × 12 Wasser,
0,3 Gt Natriumdihydrogenphosphat (wasserfrei) in
91,0 Gt Wasser.

Durch die Entwicklung wurden die vom Licht getroffenen Anteile der Kopierschicht entfernt, und es blieben die unbelichteten Bildstellen auf dem Schichtträger zurück, wobei man die der Vorlage entsprechende Druckschablone erhielt.

Von der so hergestellten Druckform konnten in einer Offsetdruckmaschine 100 000 einwandfreie Drucke hergestellt werden.

Zwecks Erhöhung der Druckauflage und Verfestigung der Druckschablone wurde die Druckform einer Wärmebehandlung unterzogen. Zu diesem Zweck wurde die getrocknete Druckform nach dem Entwickeln 10 Minuten in einem Einbrennofen auf 175°C oder 20 Minuten auf 150°C erhitzt.

Durch das Erhitzen der Druckform im Ofen trat eine Verfestigung der Druckschablone ein, und die Schicht wurde unlöslich in organischen Lösungsmitteln, wie Aceton oder Alkoholen, Dimethylformamid, Xylol oder Essigsäureanhydrid. In einer Offsetdruckmaschine wurden 350 000 einwandfreie Kopien erhalten.

Wenn das Hydroxymethylphenol-Derivat weggelassen und zwecks Aufrechterhaltung des Schichtgewichtes der Novolakanteil um den gleichen Betrag erhöht wurde, so wurde unter sonst gleichen Versuchsbedingungen nur eine Auflage von 150 000 erhalten. Ferner blieb die Druckschablone nach wie vor in organischen Lösungsmitteln löslich und war nicht resistent gegen Korrekturmittel.

Wenn anstelle des Hydroxymethylphenol-Derivats die gleiche Menge eines handelsüblichen Resolharzes verwendet wurde, wurde unter den gleichen Bedingungen gegenüber der Platte, die nur Novolak enthielt, keine Erhöhung der Druckauflage erreicht.

Der Vorteil der erfindungsgemäss nach Beispiel 1 erhaltenen Druckform geht aus der folgenden Übersicht hervor.

| Einbrennzeit in Min. | Einbrenntemperat. in °C | Zusatz von Hydroxymethylphenol | Beständigkeit gegen Lös.mittel | Druckauflage |
|---|---|---|---|---|
| 8 | 180 | + | beständig | 350 000 |
| – | – | – | keine | 100 000 |
| – | – | + | keine | 100 000 |
| 8 | 180 | – | keine | 150 000 |
| 8 | 180 | * | keine | 150 000 |
| 8 | 210 | – | keine | 180 000 |
| 5 | 240 | – | beständig | 300 000 |
| 5 | 240 | + | beständig | 500 000 |

*Zusatz von 1,3 Gt Resol anstelle von Hydroxymethylphenol

Die vorstehenden Ergebnisse zeigen deutlich, dass durch den Zusatz eines Hydroxymethylphenols gemäss der Erfindung zur Kopierschicht die Einbrenntemperatur wesentlich reduziert werden kann, um zu den gleichen kopier- und drucktechnischen Ergebnissen zu gelangen, wie sie z.B. bei 240°C ohne den Zusatz eines Hydroxymethylphenols erhalten werden.

Der Vorteil liegt im wesentlichen darin, dass Einbrennöfen mit geringerer Leistung verwendet werden können, vor allem aber darin, dass die Festigkeit von Alumimium als Schichtträger bei den erfindungsgemäss angegebenen relativ niedrigen Arbeitstemperaturen erhalten bleibt. Es ist bekannt, dass die Verformbarkeit des Aluminiums oberhalb 240°C erheblich ansteigt, was die weitere Handhabung derartiger eingebrannter Druckformen in der Praxis sehr erschwert und oftmals sogar unmöglich macht.

In den folgenden Beispielen werden weitere Beschichtungslösungen angegeben, wobei ähnliche Ergebnisse erhalten wurden. Wenn nicht gesondert vermerkt, entsprechen Herstellung und Verarbeitung der damit erhaltenen Druckplatten den in Beispiel 1 beschriebenen Bedingungen.

Beispiel 2

Mit einer Lösung von

1,36 Gt des Veresterungsproduktes aus 1 Mol des Ethoxyethylesters der 4,4-Bis-(4-hydroxyphenyl)-n-valeriansäure und 2 Mol Naphthochinon-(1,2)-diazid-(2)-5-sulfonsäurechlorid,

0,12 Gt Naphthochinon-(1,2)-diazid-(2)-4-sulfonsäurechlorid,

4,60 Gt des im Beispiel 1 angegebenen Novolaks,

1,30 Gt 1,1-Bis-(4-hydroxy-3,5-bis-hydroxymethyl-phenyl)-cyclohexan und

0,07 Gt Kristallviolett in

40 Gt Ethylenglykolmonomethylether und

50 Gt Tetrahydrofuran.

wurde eine elektrochemisch aufgerauhte und anodisierte Aluminiumplatte beschichtet, deren Oberfläche mit einer wässrigen Lösung von Polyvinylphosphonsäure behandelt worden war.

Das Ausgangsprodukt für die Herstellung des im Beispiel 2 angegebenen Hydroxymethylphenol-Derivats, das 1,1-Bis(4-hydroxy-phenyl)-cyclohexan (Schmp. 184°C), wurde in guter Ausbeute erhalten, indem durch eine Lösung von 2 Mol Phenol und 1 Mol Cyclohexanon in Toluol unter Rühren und Kühlen trockenes Salzsäuregas geleitet wurde.

Zur Verfestigung der Druckschablone, der damit verbundenen Auflagensteigerung und Resistenz gegen Lösungsmittel ist für die Druckform eine Einbrennzeit von 10 Minuten bei 170°C ausreichend.

Beispiel 3

Mit einer Lösung von

1,10 Gt des Veresterungsproduktes aus 1 Mol 2,3,4-Trihydroxy-benzophenon und 3 Mol Naphthochinon-(1,2)-diazid-(2)-5-sulfonsäurechlorid,
0,70 Gt des Veresterungsproduktes aus 1 Mol 2,2'-Dihydroxy-dinaphthyl-(1,1')-methan und 2 Mol Naphtochinon-(1,2)-diazid-(2)-5-sulfonsäurechlorid,
4,10 Gt des im Beispiel 1 angegebenen Novolaks,
1,40 Gt 4-Methyl-2,5-bis-hydroxymethyl-phenol,
0,15 Gt Naphthochinon-(1,2)-diazid-(2)-4-sulfonsäurechlorid und
0,07 Gt Kristallviolett in
40 Gt Ethylenglykolmonomethylether und
50 Gt Tetrahydrofuran

wurde eine elektrochmisch aufgerauhte und anodisierte Aluminiumplatte beschichtet.

Zur Verfestigung der Druckschablone, der damit verbundenen Auflagensteigerung und Resistenz gegenüber Lösungsmitteln ist für die Druckform eine Einbrennzeit von 10 Minuten bei 180°C ausreichend.

Beispiel 4

Mit einer Lösung von

2,0 Gt 1-(4-Methyl-benzolsulfonylimino)-2-(2-äthylphenylaminosulfonyl)-benzochinon-(1,4)-diazid-(4),
0,4 Gt eines mit Chloressigsäure modifizierten Kresol-Formaldehyd-Novolaks (beschrieben in Beispiel 5 der DE-PS 1 053 930) und 1,3 Gt 2,2-Bis-(4-hydroxy-3,5-dihydroxymethyl-phenyl)-propan in
35 Gt Ethylenglykolmonomethylether und
40 Gt Tetrahydrofuran

wurde eine mit Drahtbürsten mechanisch aufgerauhte Aluminiumplatte beschichtet.

Die so hergestellte lichtempfindliche Druckplatte wurde unter einer transparenten Negativ-Vorlage belichtet und anschliessend mit einer 1%igen Natriummetasilikat-Lösun entwickelt.

Zur Verfestigung der Druckschablone und der damit verbundenen Auflagensteigerung und Resistenz gegen Lösungsmittel war eine Einbrennzeit von 10 Minuten bei 160°C ausreichend.

Beispiel 5

Mit einer Lösung von

1,60 Gt des Veresterungsproduktes aus 1 Mol 2,4-Dihydroxy-3,5-dibrom-benzophenon und 2 Mol Naphthochinon-(1,2)-diazid-(2)-5-sulfonsäurechlorid,
4,60 Gt des im Beispiel 1 angegebenen Novolaks,
1,30 Gt Bis-(4-hydroxy-3,5-bis-hydroxymethyl-phenyl)-methan,
0,05 Gt Kristallviolett und
0,03 Gt Sudangelb GGN (C.I. 11021) in
35 Gt Ethylenglykolmonomethylether und
45 Gt Tetrahydrofuran

wurde eine elektrolytisch aufgerauhte und anodisierte Aluminiumplatte beschichtet.

Zur Verfestigung der Druckschablone war eine Einbrennzeit von 12 Minuten bei 175°C ausreichend.

Bis-(4-hydroxy-3,5-bis-hydroxymethyl-phenyl)-methan (Fp. 145°C) wurde nach den Angaben von F. Seebach [Chem. Ber. 73 (1940), 1338, bzw. Chem. Ber. 72 (1939), 1636] hergestellt.

Beispiel 6

Mit einer Lösung von

1,1 Gt des Veresterungsproduktes aus 1 Mol 2,3,4-Trihydroxy-benzophenon und 2 Mol Naphthochinon-(1,2)-diazid(2)-5-sulfonsäurechlorid,
0,8 Gt des Veresterungsproduktes aus 1 Mol 2,2'-Dihydroxy-dinaphthyl-(1,1')-methan und 2 Mol Naphthochinon-(1,2)-diazid-(2)-5-sulfonsäurechlorid,
4,2 Gt des in Beispiel 1 angegebenen Novolaks,
0,1 Gt Naphthochinon-(1,2)-diazid-(2)-4-sulfonsäurechlorid,
1,4 Gt 2,2-Bis-(4-hydroxy-3,5-bis-hydroxymethyl-phenyl)-trichlorethan und
0,07 Gt Kristallviolett in
40 Gt Ethylenglykolmonomethylether und
50 Gt Tetrahydrofuran

wurde eine elektrochemisch aufgerauhte und anodisierte Aluminiumplatte beschichtet, die mit Polyvinylphosphonsäure behandelt worden war.

Zur Verfestigung der Druckschablone, der damit verbundenen Auflagensteigerung und Resistenz gegenüber Lösungsmitteln war eine Einbrennzeit von 12 Minuten bei 170°C ausreichend.

Das Ausgangsmaterial für die Herstellung des oben angegebenen Hydroxymethylphenol-Derivats, das 2,2-Bis-(4-hydroxy-phenyl)-trichlorethan, Fp: 200°C, erhält man in guter Ausbeute nach ELBS (J. prakt, Chem. 47, (1893), Seite 60) durch Kondensation von Phenol und Chloral in Eisessig in Gegenwart von konz. Schwefelsäure.

Beispiel 7

Mit einer Lösung von

2,80 Gt einer 50%igen Lösung eines Polyorthoesters in Toluol, hergestellt aus 7,7-Bis-hydroxymethyl-5-oxa-nonanol-(1) und Orthoameisensäuretrimethylester,
0,23 Gt 2,4-Bis-(trichlormethyl)-6-(4-ethoxy-naphth-1-yl)-s-triazin,
3,30 Gt des in Beispiel 1 angegebenen Novolaks,
1,33 Gt 2,2-Bis-(4-hydroxy-3,5-bis-hydroxymethyl-phenyl)-propan und
0,04 Gt Kristallviolett in
90,00 Gt Butanon

wurde eine elektrochemisch aufgerauhte und anodisierte Aluminiumplatte beschichtet.

Die so hergestellte Druckplatte wurde 10 Sekunden unter einer 5 kW-Metallhalogenidlampe im Abstand von 110 cm bildmässig belichtet und anschliessend mit dem in Beispiel 1 angegebenen Entwickler entwickelt.

Zur Verfestigung der Druckschablone war eine

Einbrennzeit von 10 Minuten bei 180°C ausreichend.

Anstelle des oben angegebenen Polyorthoesters kann auch mit ähnlichem Ergebnis ein Polyacetal eingesetzt werden, z.B. 1,40 Gt des Polyacetals aus Triethylenglykol und 2-Ethyl-butyraldehyd.

**Patentansprüche**

1. Lichtempfindliches Gemisch, das ein wasserunlösliches, in wässrig-alkalischen Lösungen lösliches Bindemittel, ein lichtempfindliches o- oder p-Chinondiazid oder ein Gemisch aus

a) einer bei Belichtung Säure abspaltenden Verbindung und
b) einer Verbindung mit mindestens einer durch Säure spaltbaren C–O–C-Gruppe

und ein Phenolderivat enthält, dadurch gekennzeichnet, dass das Phenolderivat eine Verbindung mit 1 bis 3 Benzolkernen, die durch Einfachbindungen, Carbonyl-, Ether-, Thioether- oder gegebenenfalls substituierte Methylengruppen miteinander verbunden sind, mit mindestens einer phenolischen Hydroxygruppe und mindestens zwei Substituenten der Formel $-CH_2OR$ ist, worin R ein Wasserstoffatom, eine niedere Alkyl- oder Acylgruppe ist.

2. Lichtempfindliches Gemisch nach Anspruch 1, dadurch gekennzeichnet, dass das Phenolderivat in 4-Stellung zur Hydroxygruppe substituiert ist.

3. Lichtempfindliches Gemisch nach Anspruch 1, dadurch gekennzeichnet, dass das Phenolderivat der allgemeinen Formel II

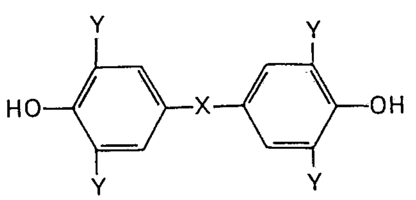

II

entspricht, worin

X eine Einfachbindung oder eine der Gruppen S, O, CO oder $CR^1R^2$ und
Y ein Wasserstoffatom oder eine $CH_2OR$-Gruppe

bedeutet, wobei R die oben angegebene Bedeutung hat,

$R^1$ und $R^2$ gleich oder verschieden sind und Wasserstoffatome, substituierte oder unsubstituierte Alkylgruppen bedeuten, die miteinander zu einem Ring verbunden sein können und nicht mehr als zwei Y Wasserstoffatome sind.

4. Lichtempfindliches Gemisch nach Anspruch 2, dadurch gekennzeichnet, dass das Phenolderivat durch Alkyl-, Alkoxy-, Cycloalkyl-, Aralkyl-, Acylgruppen oder Halogenatome substituiert ist.

5. Lichtempfindliches Gemisch nach Anspruch 1 oder 3, dadurch gekennzeichnet, dass das Phenolderivat eine Verbindung ist, in der R ein Wasserstoffatom ist.

6. Lichtempfindliches Gemisch nach Anspruch 1, dadurch gekennzeichnet, dass das Phenolderivat in einer Menge von 5 bis 60 Gew.%, bezogen auf das Gewicht der nichtflüchtigen Bestandteile, darin enthalten ist.

7. Lichtempfindliches Gemisch nach Anspruch 1, dadurch gekennzeichnet, dass es als lichtempfindliche Verbindung ein 1,2-Naphthochinon-2-diazidderivat enthält.

8. Lichtempfindliches Gemisch nach Anspruch 1, dadurch gekennzeichnet, dass das in wässrig-alkalischen Lösungen lösliche Bindemittel ein Novolak ist.

9. Lichtempfindliches Kopiermaterial, bestehend aus einem Schichtträger und einer lichtempfindlichen Schicht, die ein wasserunlösliches, in wässrig-alkalischen Lösungen lösliches Bindemittel, ein lichtempfindliches o- oder p-Chinondiazid oder ein Gemisch aus

a) einer bei Belichtung Säure abspaltenden Verbindung und
b) einer Verbindung mit mindestens einer durch Säure spaltbaren C–O–C-Gruppe

und ein Phenolderivat enthält, dadurch gekennzeichnet, dass das Phenolderivat eine Verbindung mit 1 bis 3 Benzolkernen, die durch Einfachbindungen, Carbonyl-, Ether-, Thioether- oder gegebenenfalls substituierte Methylengruppen miteinander verbunden sind, mit mindestens einer phenolischen Hydroxygruppe und mindestens zwei Substituenten der Formel $-CH_2OR$ ist, worin R ein Wasserstoffatom, eine niedere Alkyl- oder Acylgruppe ist.

10. Verfahren zur Herstellung einer Druckform, bei dem ein lichtempfindliches Kopiermaterial, bestehend aus einem Schichtträger und einer lichtempfindlichen Schicht, die ein wasserunlösliches, in wässrig-alkalischen Lösungen lösliches Bindemittel, ein lichtempfindliches o- oder p-Chinondiazid oder ein Gemisch aus

a) einer bei Belichtung Säure abspaltenden Verbindung und
b) einer Verbindung mit mindestens einer durch Säure spaltbaren C–O–C-Gruppe

und ein Phenolderivat enthält, bildmässig belichtet wird, die Nichtbildstellen der Schicht mit einer wässrig-alkalischen Entwicklerlösung ausgewaschen werden und das Material danach zur Verfestigung der Bildschicht auf erhöhte Temperatur erhitzt wird, das dadurch gekennzeichnet ist, dass man ein lichtempfindliches Material verwendet, das als Phenolderivat eine Verbindung mit 1 bis 3 Benzolkernen, die durch Einfachbindungen, Carbonyl-, Ether-, Thioether- oder gegebenenfalls substituierte Methylengruppen miteinander verbunden sind, mit mindestens einer phenolischen Hydroxygruppe und mindestens zwei Substituenten der Formel $-CH_2OR$ enthält,

worin R ein Wasserstoffatom, eine niedere Alkyl- oder Acylgruppe ist.

11. Verfahren nach Anspruch 10, dadurch gekennzeichnet, dass man das entwickelte Material auf eine Temperatur im Bereich von 150 bis 240°C erhitzt.

12. Verfahren nach Anspruch 10, dadurch gekennzeichnet, dass man das entwickelte Material 1 bis 20 Minuten erhitzt.

**Claims**

1. A light-sensitive mixture which contains a water-insoluble binder, which is soluble in aqueous-alkaline solutions, a light-sensitive o- or p-quinone-diazide or a mixture of

a) a compound which splits off an acid on exposure to light and
b) a compound having at least one C–O–C group which can be split by acid,

and a phenol derivative, wherein the phenol derivative is a compound having 1 to 3 benzene nuclei which are mutually linked by single bonds, carbonyl groups, ether groups, thioether groups or optionally substituted methylene groups, and having at least one phenolic hydroxyl group and at least two substituents of the formula $-CH_2OR$, in which R is a hydrogen atom or a lower alkyl or acyl group.

2. A light-sensitive mixture as claimed in claim 1, wherein the phenol derivative is substituted in the 4-position relative to the hydroxyl group.

3. A light-sensitive mixture as claimed in claim 1, wherein the phenol derivative corresponds to the general formula II

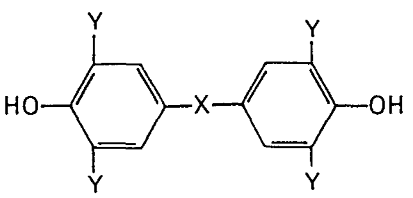

II

in which X is a single bond or one of the groups S, O, CO or $CR^1R^2$ and Y is a hydrogen atom or a $CH_2OR$ group, R having the meaning given above, and $R^1$ and $R^2$ are identical or different and are hydrogen atoms or substituted or unsubstituted alkyl groups which can be linked together to form a ring, and not more than two Y are hydrogen atoms.

4. A light-sensitive mixture as claimed in claim 2, wherein the phenol derivative is substituted by alkyl, alkoxy, cycloalkyl, aralkyl or acyl groups or by halogen atoms.

5. A light-sensitive mixture as claimed in claim 1 or 3, wherein the phenol derivative is a compound in which R is a hydrogen atom.

6. A light-sensitive mixture according to claim 1, wherein the phenol derivative is contained in a quantity of 5 to 60% by weight, relative to the weight of the non-volatile constituents.

7. A light-sensitive mixture as claimed in claim 1, wherein a 1,2-naphthoquinone-2-diazide derivative is contained as the light-sensitive compound.

8. A light-sensitive mixture as claimed in claim 1, wherein the binder which is soluble in aqueous-alkaline solutions is a novolak.

9. A light-sensitive copying material, composed of a layer support and a light-sensitive layer which contains a water-insoluble binder, which is soluble in aqueous-alkaline solutions, a light-sensitive o- or p-quinone-diazide or a mixture of

a) a compound which splits off an acid on exposure to light and
b) a compound having at least one C–O–C group which can be split by acid,

and a phenol derivative, wherein the phenol derivative is a compound having 1 to 3 benzene nuclei which are mutually linked by single bonds, carbonyl groups, ether groups, thioether groups or optionally substituted methylene groups, and having at least one phenolic hydroxyl group and at least two substituents of the formula $-CH_2OR$, in which R is a hydrogen atom or a lower alkyl or acyl group.

10. A process for preparing a printing form, in which a light-sensitive copying material composed of a layer support and a light-sensitive layer which contains a water-insoluble binder, which is soluble in aqueous-alkaline solutions, a light-sensitive o- or p-quinone-diazide or a mixture of

a) a compound which splits off an acid on exposure to light and
b) a compound having at least one C–O–C group which can be split by acid,

and a phenol derivative, is exposed imagewise, the non-image areas of the layer are washed out with an aqueous-alkaline developer solution and the material is then heated to an elevated temperature in order to harden the image layer, wherein a light-sensitive material is used which, as the phenol derivative, contains a compound having 1 to 3 benzene nuclei which are mutually linked by single bonds, carbonyl groups, ether groups, thioether groups or optionally substituted methylene groups, and having at least one phenolic hydroxyl group and at least two substituents of the formula $-CH_2OR$, in which R is a hydrogen atom or a lower alkyl or acyl group.

11. A process as claimed in claim 10, wherein the developed material is heated to a temperature in the range from 150 to 240°C.

12. A process as claimed in claim 10, wherein the developed material is heated for 1 to 20 minutes.

**Revendications**

1. Mélange photosensible qui contient un liant insoluble dans l'eau et soluble dans des solutions

aqueuses alcalines, un o- ou p-chinonediazide photosensible ou un mélange constitué de:

a) un composé engendrant un acide par exposition et
b) un composé ayant au moins un groupe C–O–C scindable par un acide

et un dérivé de phénol, caractérisé en ce que le dérivé de phénol est un composé ayant de 1 à 3 noyaux benzène qui sont reliés entre eux par de simples liaisons, des groupes carbonyle, des groupes éther, des groupes thioéther, ou des groupes méthylène éventuellement substitués, avec au moins un groupe hydroxy phénolique et au moins deux substituants de formule $-CH_2OR$, où R est un atome d'hydrogène, un groupe alcoyle ou acyle inférieur.

2. Mélange photosensible selon la revendication 1, caractérisé en ce que le dérivé de phénol est substitué en position 4 par rapport au groupe hydroxy.

3. Mélange photosensible selon la revendication 1, caractérisé en ce que le dérivé de phénol correspond à la formule générale II

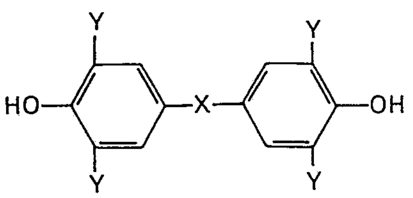

II

dans laquelle:
X représente une simple liaison ou un des groupes S, O, CO ou $CR^1R^2$ et
Y représente un atome d'hydrogène ou un groupe $CH_2OR$, dans lequel R a la signification indiquée ci-dessus,
$R^1$ et $R^2$ sont identiques ou différents et représentent des atomes d'hydrogène, des groupes alcoyle substitués ou non-substitués qui peuvent être reliés l'un avec l'autre en un noyau, et deux substituants Y au plus sont des atomes d'hydrogène.

4. Mélange photosensible selon la revendication 2, caractérisé en ce que le dérivé de phénol est substitué par des groupes alcoyle, alcoxy, cycloalcoyle, aralcoyle, acyle ou par des atomes d'halogène.

5. Mélange photosensible selon l'une des revendications 1 ou 3, caractérisé en ce que le dérivé de phénol est un composé dans lequel R est un atome d'hydrogène.

6. Mélange photosensible selon la revendication 1, caractérisé en ce que le dérivé de phénol y est contenu en une quantité représentant de 5 à 60% en poids, par rapport au poids des constituants non volatils.

7. Mélange photosensible selon la revendication 1, caractérisé en ce que, comme composé photosensible, il contient un dérivé de 1,2-naphtoquinone-2-diazide.

8. Mélange photosensible selon la revendication 1, caractérisé en ce que le liant soluble dans des solutions aqueuses alcalines est une novolaque.

9. Matériau à copier photosensible composé d'un support et d'une couche photosensible qui contient un liant insoluble dans l'eau et soluble dans des solutions aqueuses alcalines, un o- ou p-quinonediazide photosensible à la lumière ou un mélange constitué de:

a) un composé engendrant un acide par exposition, et
b) un composé ayant au moins un groupe C–O–C scindable par un acide,

et un dérivé de phénol, caractérisé en ce que le dérivé de phénol est un composé ayant de 1 à 3 noyaux benzène qui sont reliés entre eux par de simples liaisons, des groupes carbonyle, des groupes éther, des groupes thioéther, ou des groupes méthylène éventuellement substitués, avec au moins un groupe hydroxy phénolique et au moins deux substituants de formule $-CH_2OR$ où R est un atome d'hydrogène, un groupe alcoyle ou acyle inférieur.

10. Procédé pour la préparation d'une forme d'impression, dans lequel on expose selon une image un matériau de reproduction photosensible, composé d'un support et d'une couche photosensible qui contient un liant insoluble dans l'eau et soluble dans des solutions aqueuses alcalines, un o- ou p-quinonediazide photosensible ou un mélange constitué de:

a) un composé engendrant un acide par exposition, et

b) un composé ayant au moins un groupe C–O–C scindable par un acide,

et un dérivé de phénol, on élimine les zones de non-image de la couche par lavage avec une solution de développateur aqueuse-alcaline et on chauffe le matériau à une température élevée pour durcir la couche d'image, lequel procédé est caractérisé en ce qu'on utilise un matériau photosensible qui contient comme dérivé de phénol un composé ayant de 1 à 3 noyaux benzène qui sont reliés les uns aux autres par de simples liaisons, des groupes carbonyle, des groupes éther, des groupes thioéther, ou des groupes méthylène éventuellement substitués, avec au moins un groupe hydroxy phénolique et au moins deux substituants de formule $-CH_2OR$ où R est un atome d'hydrogène, un groupe alcoyle ou acyle inférieur.

11. Procédé selon la revendication 10, caractérisé en ce qu'on chauffe le matériau développé à une température comprise entre 150 et 240°C.

12. Procédé selon la revendication 10, caractérisé en ce qu'on chauffe le matériau développé pendant 1 à 20 minutes.